# EUROPEAN PATENT APPLICATION

(11) **EP 1 167 983 A2**
(43) Date of publication of application: **02.01.2002**
(21) Application number: 01303626.4
(22) Date of filing: 20.04.2001
(51) Int. Cl.: G01R 19/165, G09G 3/32

(54) **Display of input signals**

(30) Priority: 25.04.2000 GB 0010094
(71) Applicant: Omron Europe B.V., 2132 JD Hoofddorp (NL)
(72) Inventor: Foreman, Tim, 5626 VV Eindhoven (NL); Scheffer, Frederik, 5244 HN Rosmalen (NL); Haker, Klement, 4191 HT Geldermalsen (NL)
(74) Representative: Calderbank, Thomas Roger

(57) **Abstract**

In order to display signals, particularly to display the status of these signals when those signals are input to a programmable logic controller, the value of each input signal is monitored in a predetermined sequence of read operations. An output signal of a first value is generated if the value of the input signal is at a predetermined value at the time of the read operation or has been at that predetermined value in the time since the immediately preceding read operation. An output signal of a second value is generated if neither of these conditions applies. Different display indicators are thus generated when the first and second output signals are generated. This enables the display to give an accurate indication of the status of the signals.

## Description

The present invention relates to the display of input signals and relates particularly, but not exclusively, to the display of the status of those signals when those signals are input to a programmable logic controller (PLC).

This simplest way of displaying the status of signals is to connect each signal via a suitable driver to a corresponding element such as an LED, so that the LED is on when the signal is asserted and the LED is off at other times. However, as the number of possible input signals grows, space considerations makes it more difficult to link the LEDs to the main PWB which receives all the input signals. A common way to solve this problem is to drive an LED matrix under the control of a processor, which poles the input signals. Thus, in this case, the LED matrix is connected to the processor rather than receiving the input signals directly. This arrangement is satisfactory if the signals represent some status of a device controlled by the processor, which is controlled at a lower rate than the refresh rate of the LED matrix. In this case, the process will always be synchronous with the signals, since the signals are themselves generated by the processor.

However, if the input signals do not come from the processor, but come from an external source, there will be asynchronous with the processor. Indeed, they may be received a rate higher than the rate at which the processor poles the input signals. In such circumstances, the control of the LED matrix may not be satisfactory.

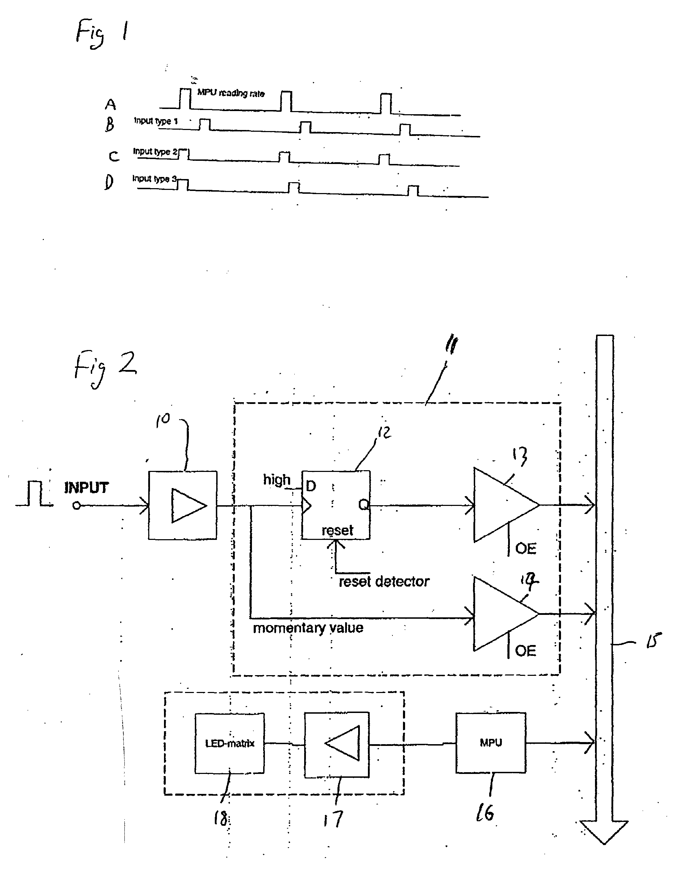

Fig. 1 of the accompanying drawings illustrates a problem that occurs. In Fig. 1, line A shows pulses representing the reading times of the processor (MPU) of a PLC. Line B shows inputs of the same pulse rate as the reading time of the processor, but in a different phase. Line C shows input pulses having the same rate as the reading rate of the processor, which are in phase, and line D shows input pulses which have a different rate from that of the reading rate of the processor. If the processor attempts to display information about the inputs, then the results differ for inputs B, C and D. For inputs B, no outputs are generated since there is no time at which the processor reads a pulse. For type C, a display will be generated each time the processor carries out a reading operation, and in type B a display will be generated at some processor reading times, and not at others. Thus, the status of the inputs does not have a clear relationship to the input signals themselves.

It has been realised that this problem can be solved by considering the input history between one read action of the processor and the next.

At its most general, the invention proposes that information about pulses which occur between one processor read operation and the preceding read operation are detected. It then becomes possible for the processor to control a display which illustrates the statuses of the signals, using both the value of the pulses at the time of the read operation and the value the pulses have had between one read operation and the preceding one.

Thus, according to the present invention there may be provided a method of displaying the status of input signals using a plurality of display elements, wherein for each input signal, the value of the input signal is monitored in a predetermined sequence of read operations to generate an output signal of a first value if either: (a) the value of the input signal is at a predetermined value at the time of the read operation, or (b) the value of the input signal has been at the predetermined value before the current read operation but after the immediately preceding read operation, and to generate an output signal of a second value if either (a) nor (b) applies at the time of the current read operation, and respectively different display indications are generated by a display element corresponding to said input signal when said output signals of said first and second values are generated, thereby to display the status of each said input signal.

In particular a rising (or falling) edge of an input pulse is detected, and the occurrence of that edge stored, and the read operation of the processor comprises detecting either a pulse, or a stored pulse edge. The read operation then resets the store.

Although the invention has been described above in terms of the method of operation thereof, the invention also relates to an apparatus for carrying out such a method.

An embodiment of the present invention will now be described in detail, by way of example, with reference to the accompanying drawings, in which:
Fig. 1 is a timing chart showing the disadvantages of the known arrangements, and has already been described;
Fig. 2 is a schematic block diagram of part of a system for displaying input signals, being an embodiment of the invention;
Fig. 3 is a timing chart similar to Fig. 1, but illustrating the effect of the present invention.

Referring to Fig. 2, input pulses of an input signal are input via a buffer 10 to the pulse detector circuit 11. The pulse detector circuit 11 has a rising edge detector 12 in the form of a D flip-flop, and output buffers 13 and 14, one of which receives the output of the rising edge detector 12, and one of which receives the instantaneous value of the input from buffer 10.

The buffers 13 and 14 are connected via a data bus 15 to a processor 16. The processor 16 is also connected via a buffer 17 to a display 18 in the form of an LED matrix. The processor 16 controls the display 18 in dependence on the detection of the information at the buffers 13,14. In particular, the processor 16 triggers an output to the display 18 if either of the two buffers 13,14 has an output. That will occur in two situations depending on the relationship between the times the processor reads the buffers 13,14 and the inputs to the buffer 10. If the read time of the processor 16 coincides with the time of an input pulse to the buffer 10, then there will be an output from buffer 14 and the display 18 will be triggered. The alternative is that the pulse has occurred between the current read time of the processor 16, and the immediately preceding read time. In that case, the rising edge detector 12 will have detected the pulse, and there will thus be an output at buffer 13, which will be read by the processor 16. Again, in that case, the display 18 will be triggered. At the same time, the processor 16 generates an output which resets the rising edge detector.

It should be noted that for the sake of clarity, Fig.2 shows a single buffer 17 between the processor 16 and the display 18. In fact, each LED is the matrix of display 18 will have a separate output from the processor 16 which output will pass via a respective separate buffer 17 to the corresponding LEX of display 18.

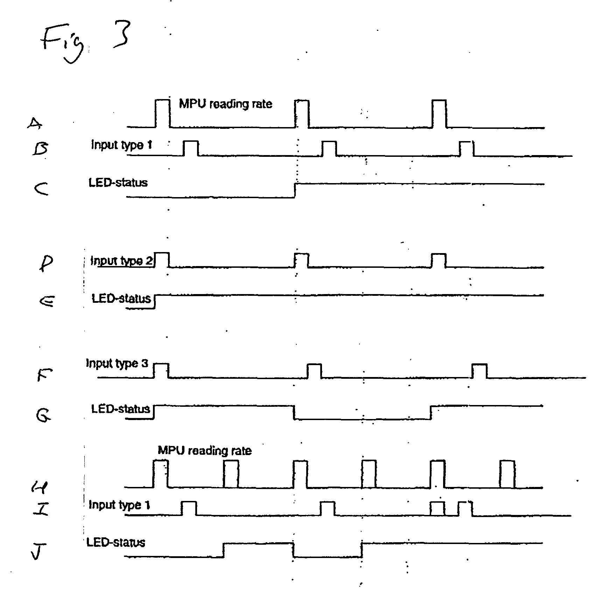

The effect of this operation is illustrated in Fig. 3, in which the lines A to I illustrate different operations in the same line sequence.

Line A in Fig. 3 shows the read times of the processor 16. Line B then illustrates the case where inputs to the buffer 10 have the same period, but are out of phase, with the read times of the processor 16. The first time the processor carries out a read operation, there is no current pulse at buffer 14, and there has been no previous pulse to generate an output at buffer 13. Thus, nothing is read by the processor 16 and the display 18 has an off status, as illustrated at line C. Between one processor read time and the next, there is a pulse input to buffer 10, whose leading edge detected by the leading edge detector 12, that there will then be an output buffer 13. This is read in the second read operation of the processor 16, so that the display status changes to on. Although the leading edge detector 12 is reset at the read time, there will then be another pulse before the next read operation, so again the leading edge detector 12 will detect that pulse and buffer 13 will have an output. Hence, in the arrangement illustrated by lines A, B and C the display 18 will have an on status for all pulses except the first.

Line D in Fig. 3 illustrates the case where the input pulses to buffer 10 have the same period, and are in phase, with the read times of the processor 16. In this case, the first time the processor 16 carries out a read operation, there is an output at buffer 14, and the processor 16 turns the display 18 to on status. The next time the processor 16 carries out a read operation, there is again an output from buffer 14, so the display remains in the on status. The situation is thus similar to the pulses shown in line B, except initially.

Lines F and G then illustrate the situation where the pulses have a period which is greater than the read rate of the pulses. It is assumed that the first pulse coincides with a read time. Since that is the case, at the time of that first read operation of the processor 16, there is an output from buffer 14, so the display 18 is turned to on status. Since the read operation resets the leading edge detector 12, there is then no output at buffer 13 at the time of the next read operation. Moreover, since the next pulse has not occurred, buffer 14 has no output. Therefore, at the second read operation, the display status returns to off. However, the next pulse triggers the leading edge detector, so at the third read operation there will be an output at buffer 13, and thus the display will change to on status.

It will remain in on status until there is no pulse between one read operation and the next.

Line H in Fig. 3 illustrates the situation where the read rate of the processor 16 is increased, but it is assumed that the input pulses to buffer 10 shown at line I are the same as those at line B. In this case, the processor 16 switches the display on and off as shown in line J in a similar way to that of line G, but with a shorter duration. There are now many cases where no pulse occurs between one read operation and the next, and where the processor 16 thus turns off the display 18.

Thus, at normal processor sampling rates of, e.g. 25 or 50Hz, it becomes possible to generate a visualisation of the input signal using an LED matrix display. The relevant part of the display is switched on either if the signal is on at the sample time, or if a low-to-high level change has occurred between one sample operation and the next. The displays are not dependent on the inputs being in phase with the read operation. The invention also permits a very short single pulse to be made visible to the human eye.

The discussion of Figs 2 and 3 above consider a single signal in the form of a train of pulses and usually a single element of the LED matrix 18 will display the status of that signal. However, there will normally be a plurality of signals being investigated, each of which will be monitored in the way discussed above with the reference to Figs 2 and 3, and the status of each of which will then be indicated by respectively different elements of the LED matrix. It is, however, possible for different or related signals to be displayed by the same element of the LED matrix 18, ie there does not have to be a one-to-one correspondence between the number of signals being investigated and the number of elements of the LED matrix 18.

## Claims

1. A method of displaying the status of input signals using a plurality of display elements wherein, for each input signal, the value of the input signal is monitored in a predetermined sequence of read operations to generate an output signal of a first value if either: (a) the value of the input signal is at a predetermined value at the time of the read operation, or (b) the value of the input signal has been at the predetermined value before the current read operation but after the immediately preceding read operation, and to generate an output signal of a second value if neither (a) nor (b) applies at the time of the current read operation, and respectively different display indications are generated by a display element corresponding to said input signal when said output signals of said first and second values are generated, thereby to display the status of each said input signal.

2. A method according to claim 1, wherein each said input signal is in the form of a train of pulses, and the occurrence of a rising pulse edge between one read operation and the next is detected and stored, thereby to enable the occurrence of situation (b) to be determined.

3. A method according to claim 2, wherein the storage of said occurrence is in a storage device which is reset at each read operation.

4. An apparatus for displaying the status of input signals, comprising:
first means for generating a signal when the value of each input signal is at a predetermined value;
second means for generating a signal when the value of each input signal has been at said predetermined value;
a processor for monitoring said first and second means in a predetermined sequence of read operations, and to generate an output signal of a first value if either: (a) the value of the input signal is at a predetermined value at the time of the read operation or (b) the value of the input signal has been at the predetermined value before the current read operation but after the immediately preceding read operation, and to generate an output signal of a second value if either (a) nor (b) applies at the time of the current read operation; and
display elements corresponding to said input signals, each display element being arranged to generate respectively different display indicators when said output signals of said first and second values are generated for the corresponding input signal, thereby to display the status of each said input signal.
